(19) **Europäisches Patentamt European Patent Office Office européen des brevets**

(11) **EP 4 495 613 B1**

(12) **EUROPEAN PATENT SPECIFICATION**

(45) Date of publication and mention of the grant of the patent:
**03.06.2026 Bulletin 2026/23**

(21) Application number: **24182047.1**

(22) Date of filing: **13.06.2024**

(51) International Patent Classification (IPC):
**G01R 31/367** (2019.01)    **G01R 31/374** (2019.01)
**G01R 31/3842** (2019.01)    **G01R 31/389** (2019.01)
**G01R 31/392** (2019.01)    **B60L 58/16** (2019.01)

(52) Cooperative Patent Classification (CPC):
**G01R 31/389; B60L 58/16; G01R 31/367;**
**G01R 31/374; G01R 31/3842; G01R 31/392;**
**Y02E 60/10**

(54) **BATTERY CAPACITY CALCULATION DEVICE AND BATTERY CAPACITY CALCULATION METHOD**

VORRICHTUNG ZUR BERECHNUNG DER BATTERIEKAPAZITÄT UND VERFAHREN ZUR BERECHNUNG DER BATTERIEKAPAZITÄT

DISPOSITIF DE CALCUL DE CAPACITÉ DE BATTERIE ET PROCÉDÉ DE CALCUL DE CAPACITÉ DE BATTERIE

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **17.07.2023 CN 202310875646**

(43) Date of publication of application:
**22.01.2025 Bulletin 2025/04**

(73) Proprietor: **Lenovo (Beijing) Limited Beijing 100085 (CN)**

(72) Inventors:
 • **HIRANO, Yuta Kanagawa (JP)**
 • **TAN, Yue Beijing (CN)**
 • **YAMAGUCHI, Hiromitsu Kanagawa (JP)**
 • **ARAI, Daisuke Kanagawa (JP)**
 • **KAWAKAMI, Jumpei Kanagawa (JP)**

(74) Representative: **Openshaw & Co. 8 Castle Street Farnham, Surrey GU9 7HR (GB)**

(56) References cited:
 **JP-A- 2019 211 248    US-A1- 2005 154 544**

**Description**

BACKGROUND OF THE INVENTION

Field of the Invention

The present invention relates to a battery capacity calculation device and a battery capacity calculation method.

Description of the Related Art

Developing products that users can use for a long period of time leads to reduce carbon emissions. It is expected that the amount of electronic waste (E-waste) is reduced and environmental problems are improved by having users replace batteries of electronic apparatuses, such as laptop personal computers (PCs) in a timely manner. Therefore, there is a demand for a function of prompting a user to replace a battery in a timely manner.

As a function for notifying the user of the deterioration degree of the battery, there is a function of estimating a state of the battery based on a capacity retention rate and the number of cycles and displaying the state. The capacity retention rate is obtained by dividing a full charge capacity (FCC) by a design capacity. In addition, a related art is known in which a full charge capacity is calculated based on a current value from a fully charged state of the battery to a completely discharged state.

A device disclosed in Japanese Unexamined Patent Application Publication No. 2021-125320 selects an estimation method of a full charge capacity according to a state of a battery and estimates the full charge capacity by using the selected method.

JP 2019 211248 A discloses a secondary battery parameter estimating device.

SUMMARY OF THE INVENTION

In the related art of estimating a full charge capacity, it is necessary to completely discharge the battery, and thus the calculation frequency of the full charge capacity is low.

An object of the present invention is to provide a battery capacity calculation device and a battery capacity calculation method capable of calculating a full charge capacity at a high frequency.

A battery capacity calculation device according to a first aspect includes: a controller, in which the controller is configured to acquire, while a battery is in charge, a first voltage value and a charge current value of the battery, acquire, while charging of the battery is in pause, a second voltage value of the battery, calculate an impedance value of the battery by using the first voltage value, the second voltage value, and the charge current value, calculate an impedance growth that is a ratio of the impedance value to an initial impedance value recorded in a memory in advance, acquire the number of cycles of the battery, acquire time until a temperature of the battery falls within a predetermined temperature range and an output voltage value of the battery falls within a predetermined voltage range, and calculate a full charge capacity of the battery by using the number of cycles, the impedance growth, and the time.

According to the first aspect, the controller may be configured to calculate the full charge capacity according to an expression: FCC = 1.0 + a * CYC + b * HTVT + c * IMP, and in the expression, FCC is the full charge capacity, CYC is the number of cycles, HTVT is the time, IMP is the impedance growth, and a, b, and c are predetermined coefficients.

According to the first aspect, the controller may be configured to correct the impedance value according to the temperature of the battery while the battery is in charge.

According to the first aspect, the controller may be configured to record the calculated full charge capacity and time information at a time point when the full charge capacity is calculated, in a memory, and calculate time during when the full charge capacity of the battery is equal to or less than a predetermined capacity, by using the full charge capacity and the time information recorded in the memory.

A battery capacity calculation device according to a second aspect according to the present invention includes: a controller, in which the controller is configured to acquire, while a battery is in charge, a first voltage value and a charge current value of the battery, acquire, while charging of the battery is in pause, a second voltage value of the battery, calculate an impedance value of the battery by using the first voltage value, the second voltage value, and the charge current value, calculate an impedance growth that is a ratio of the impedance value to an initial impedance value recorded in a memory in advance, acquire the number of cycles of the battery, and calculate a full charge capacity of the battery by using the number of cycles and the impedance growth.

A battery capacity calculation method according to a third aspect includes: a step of acquiring, while a battery is in charge, a first voltage value and a charge current value of the battery; a step of acquiring, while charging of the battery is in pause, a second voltage value of the battery; a step of calculating an impedance value of the battery by using the first voltage value, the second voltage value, and the charge current value; a step of calculating an impedance growth that is a ratio of the impedance value to an initial impedance value recorded in a memory in advance; a step of acquiring the number of cycles of the battery; a step of acquiring time until a temperature of the battery falls within a predetermined temperature range and an output voltage value of the battery falls within a predetermined voltage range; and a step of calculating a full charge capacity of the battery by using the number of cycles, the impedance growth, and the time.

A battery capacity calculation method according to a fourth aspect according to the present invention includes: a step of acquiring, while a battery is in charge, a first voltage value and a charge current value of the battery; a step of acquiring, while charging of the battery is in pause, a second voltage value of the battery; a step of calculating an impedance value of the battery by using the first voltage value, the second voltage value, and the charge current value; a step of calculating an impedance growth that is a ratio of the impedance value to an initial impedance value recorded in a memory in advance; a step of acquiring the number of cycles of the battery; and a step of calculating a full charge capacity of the battery by using the number of cycles and the impedance growth.

The battery capacity calculation device and the battery capacity calculation method of present invention can calculate a full charge capacity at a high frequency.

BRIEF DESCRIPTION OF THE DRAWINGS

FIG. 1 is a block diagram illustrating a configuration example of hardware of an electronic apparatus according to a first embodiment of the present invention.
FIG. 2 is a block diagram illustrating an example of a configuration of a battery according to the first embodiment of the present invention.
FIG. 3 is a flowchart illustrating an example of an impedance value calculation process according to the first embodiment of the present invention.
FIG. 4 is a diagram illustrating an example of a change in voltage of a battery according to the first embodiment of the present invention.
FIG. 5 is a diagram illustrating an example of a change in voltage of the battery according to the first embodiment of the present invention.
FIG. 6 is a diagram illustrating an example of an impedance of the battery according to the first embodiment of the present invention.
FIG. 7 is a diagram illustrating an example of a correction coefficient according to the first embodiment of the present invention.
FIG. 8 is a flowchart illustrating an example of a capacity calculation process according to the first embodiment of the present invention.
FIG. 9 illustrates an example of a relationship between the number of cycles and a capacity retention rate and a relationship between the number of cycles and an impedance growth according to the first embodiment of the present invention.
FIG. 10 is a diagram illustrating an example of a relationship between the impedance growth and the capacity retention rate of the battery according to the first embodiment of the present invention.
FIG. 11 is a diagram illustrating an example of a relationship between the impedance growth and the capacity retention rate of the battery according to the first embodiment of the present invention.
FIG. 12 is a block diagram illustrating an example of a configuration of the battery according to a second embodiment of the present invention.
FIG. 13 is a flowchart illustrating an example of the capacity calculation process according to the second embodiment of the present invention.
FIG. 14 is a diagram illustrating an example of a time change in full charge capacity of the second embodiment of the present invention.

DETAILED DESCRIPTION OF THE INVENTION

Hereinafter, an embodiment of the present invention will be described with reference to the drawings.

(First Embodiment)

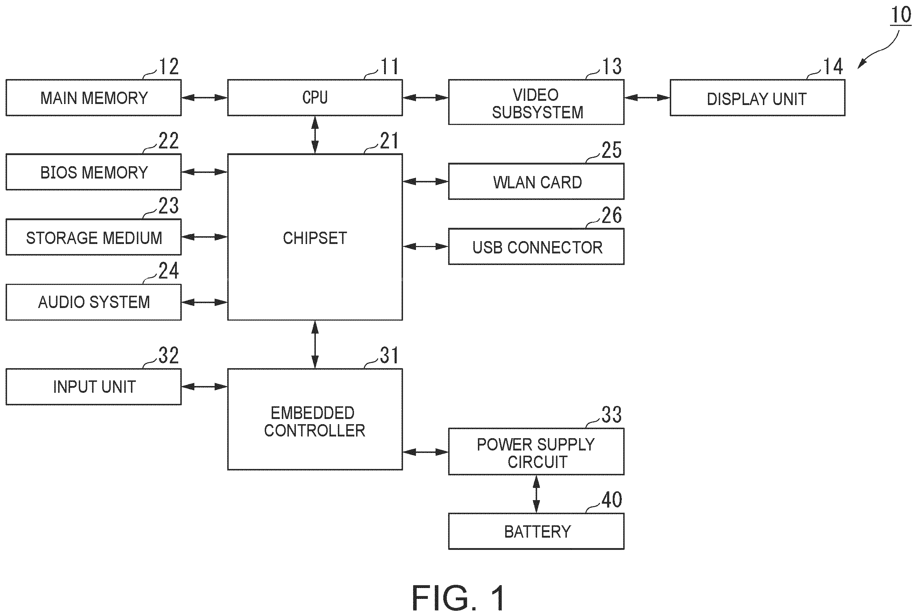

A first embodiment of the present invention will be described. FIG. 1 is a block diagram illustrating an example of a hardware configuration of an electronic apparatus 10 according to the present embodiment.
The electronic apparatus 10 includes a CPU 11, a main memory 12, a video subsystem 13, a display unit 14, a chipset 21, a BIOS memory 22, a storage medium 23, an audio system 24, a WLAN card 25, a USB connector 26, embedded controller 31, an input unit 32, a power supply circuit 33, and a battery 40.

The CPU 11 executes various types of arithmetic processing with program control and controls the entire electronic apparatus 10. For example, the CPU 11 executes processing based on programs of an operating system (OS) and a basic input output system (BIOS). The CPU 11 is an example of a processor.

The main memory 12 is a writable memory used as a read area for an execution program of the CPU 11 or as a work area for writing processing data of the execution program. The main memory 12 includes, for example, a plurality of dynamic random access memory (DRAM) chips. This execution program includes an OS, various drivers for operating peripheral equipment, various services/utilities, an application program, and the like.

The video subsystem 13 is a subsystem for realizing a function related to image display and includes a video controller. The video controller processes a drawing instruction from the CPU 11, writes the processed drawing information to the video memory, reads the drawing information from the video memory, and outputs the drawing information as drawing data (display data) to the display unit 14.

The display unit 14 is, for example, a liquid crystal display or an organic EL display, and displays a display screen based on the drawing data (display data) output from the video subsystem 13.

The chipset 21 includes a controller for a universal serial bus (USB), a serial AT attachment (ATA), a serial peripheral interface (SPI) bus, a peripheral component interconnect (PCI) bus, a PCI-Express bus, low pin count (LPC) bus, and the like, and a plurality of devices is connected to the chipset 21. For example, the BIOS memory 22, the storage medium 23, the audio system 24, the WLAN card 25, the USB connector 26, and the embedded controller 31, which are described later, are included as a plurality of devices.

The BIOS memory 22 includes an electrically rewritable non-volatile memory such as an electrically erasable programmable read only memory (EEPROM) or a flash ROM. The BIOS memory 22 stores, for example, a program of a BIOS, a system firmware for controlling the embedded controller 31, and the like. The BIOS memory 22 is an example of a sub memory.

The storage medium 23 includes a hard disk drive (HDD), a solid state drive (SSD), and the like. For example, the storage medium 23 stores an OS, various drivers, various services/utilities, an application program, and various data.

A microphone and a speaker (not illustrated) are connected to the audio system 24, and the audio system 24 records, plays, and outputs sound data. The microphone and the speaker are built in the electronic apparatus 10 as an example.

The wireless local area network (WLAN) card 25 is connected to a network by a wireless LAN, and performs data communication. For example, when the WLAN card 25 receives data from the network, the WLAN card 25 generates an event trigger indicating that the data has been received. The USB connector 26 is a connector for connecting peripheral equipment using USB.

The input unit 32 collectively indicates input devices (input equipment) included in the electronic apparatus 10. The input device, which is included in the input unit 32, outputs input information input by a user's operation to the embedded controller 31.

The power supply circuit 33 includes, for example, a DC/DC converter, a charge/discharge unit, an AC/DC adapter, and the like. For example, the power supply circuit 33 converts a direct current voltage supplied from an external power supply such as an AC adapter (not illustrated) or the battery 40 into a plurality of voltages required for operating the electronic apparatus 10. In addition, the power supply circuit 33 supplies electric power to each unit of the electronic apparatus 10 based on the control from the embedded controller 31.

The battery 40 is a secondary battery such as a lithium-ion battery, for example. When the electric power is supplied to the electronic apparatus 10 from an external power supply, the battery 40 is charged via the power supply circuit 33. When the electric power is not supplied to the electronic apparatus 10 from an external power supply, the battery 40 outputs the accumulated electric power as operating power of the electronic apparatus 10 via the power supply circuit 33.

The embedded controller 31 is a one-chip microcomputer that monitors and controls various devices (peripheral devices, sensors, and the like) regardless of a state of a system of the electronic apparatus 10. The embedded controller 31 includes a CPU, a ROM, a RAM, a plurality of channels of A/D input terminals and a D/A output terminal, a timer, and a digital input/output terminal, which are not illustrated. The input unit 32, the power supply circuit 33, and the like are connected to the digital input/output terminal of the embedded controller 31, and the embedded controller 31 controls operations thereof. In addition, the embedded controller 31 performs control such as a change in clock frequency of the CPU 11 via the chipset 21.

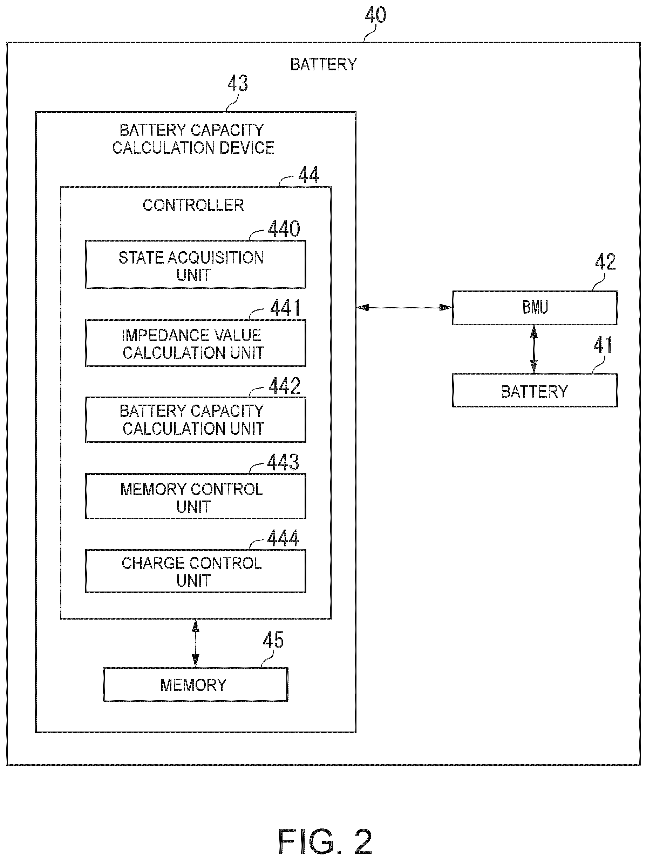

FIG. 2 illustrates an example of a configuration of the battery 40 according to the present embodiment. The battery 40 includes a battery 41, a battery management unit (BMU) 42, and a battery capacity calculation device 43. The battery capacity calculation device 43 may be included in the BMU 42.

For example, the battery 41 is a lithium ion battery. The BMU 42 monitors various states of the battery 41 and acquires information related to various states from the battery 41. For example, the BMU 42 acquires a voltage value, a current value, a temperature, and the like of the battery 41 from the battery 41.

The battery capacity calculation device 43 includes a controller 44 and a memory 45. The controller 44 includes a micro processing unit (MPU) or the like. The memory 45 includes a storage medium, such as a RAM.

The controller 44 includes a state acquisition unit 440, an impedance value calculation unit 441, a battery capacity calculation unit 442, a memory control unit 443, and a charge control unit 444 as a functional configuration of processing executed by the MPU. The function of the controller 44 may be implemented in a battery firmware.

The state acquisition unit 440 acquires information related to various states of the battery 41 from the BMU 42. The impedance value calculation unit 441 calculates an impedance value of the battery 41 by using the information acquired from the BMU 42. The battery capacity calculation unit 442 calculates a full charge capacity of the battery 41 by using the information acquired from the BMU 42 and the impedance value calculated by the impedance value calculation unit 441. The memory control unit 443 controls the reading and writing of data between the controller 44 and the memory 45. The charge control unit 444 controls the charging of the battery 41 via the BMU 42.

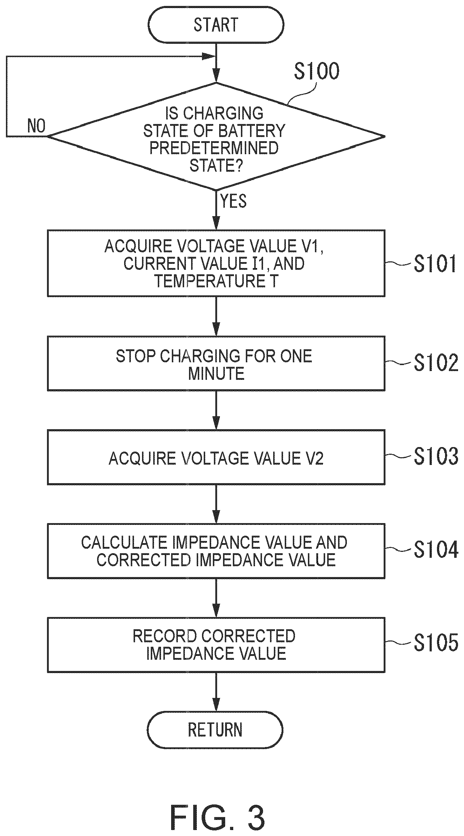

An impedance value calculation process executed by the controller 44 will be described with reference to FIG. 3. FIG. 3 illustrates an example of the impedance value calculation process according to the present embodiment. The controller 44 executes the impedance value calculation process illustrated in FIG. 3 while the battery 41 is in charge.

(Step S100)

The state acquisition unit 440 acquires information related to a state of charge (SoC) of the battery 41 from the BMU 42 each time a predetermined time elapses. The SoC indicates a charging state of the battery 41. When the battery 41 is in a fully charged state, the SoC is 100%, and when the battery 41 is in a completely discharged state, the SoC is 0%. The state acquisition unit 440 determines whether or not the charging state indicated by the SoC is a predetermined state. The predetermined state corresponds to a state in which the electronic apparatus 10 is in operation by receiving electric power from the battery 41 and the impedance of the battery 41 is stable. For example, the predetermined state corresponds to 60%, 65%, 70%, 75%, or 80% of the SoC.

When the charging state of the battery 41 is not the predetermined state, the controller 44 executes step S100 again. When the charging state of the battery 41 is the predetermined state, the controller 44 executes the following step S101.

When the SoC is 60%, 65%, 70%, 75%, or 80%, the controller 44 calculates the impedance value of the battery 41 as follows. Therefore, the controller 44 is capable of calculating the impedance value of the battery 41 at a high frequency.

(Step S101)

The state acquisition unit 440 acquires information related to a voltage value V1, a current value I1, and a temperature T of the battery 41 from the BMU 42.

(Step S102)

After step S101 is executed, the charge control unit 444 stops the charging of the battery 41 for one minute. The time during when the charge control unit 444 stops the charging is not limited to one minute.

(Step S103)

After step S102 is executed, the state acquisition unit 440 acquires information related to a voltage value V2 of the battery 41 from the BMU 42.

(Step S104)

After step S103 is executed, the impedance value calculation unit 441 calculates the impedance value of the battery 41 by using the voltage value V1, the voltage value V2, and the current value I1. In addition, the impedance value calculation unit 441 corrects the impedance value by using the temperature T and obtains a corrected impedance value.

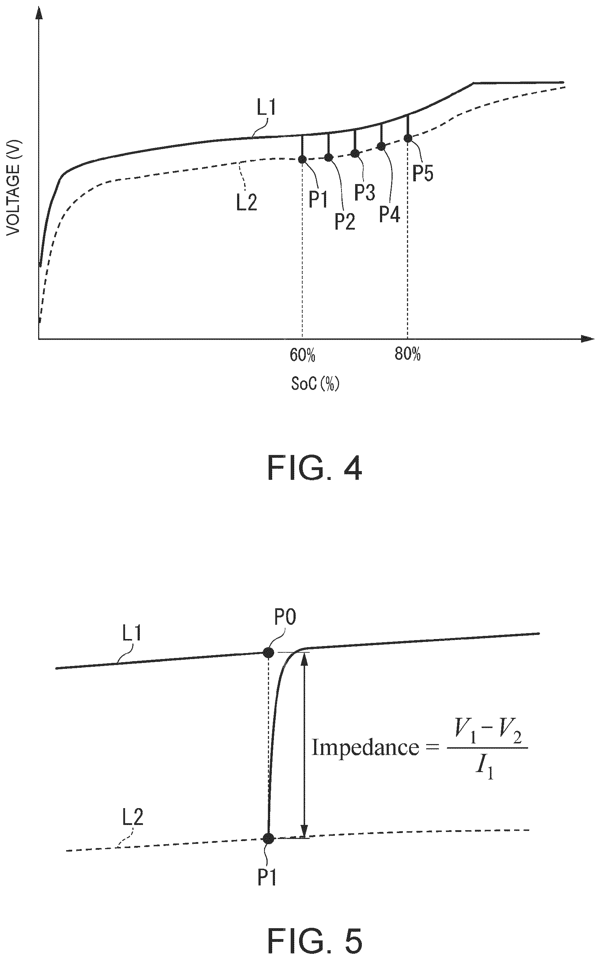

A method of calculating the impedance value of the battery 41 by the impedance value calculation unit 441 will be described with reference to FIGS. 4 and 5. FIG. 4 illustrates an example of a change in voltage of the battery 41 while the battery 41 is in charge. FIG. 5 is an enlarged diagram of a part of FIG. 4.

In FIG. 4, a horizontal axis of a graph indicates the SoC, and a vertical axis of the graph indicates a voltage. In FIG. 4, a line L1 indicates closed circuit voltages (CCV) of the battery 41 while the battery 41 is in charge. In FIG. 4, points P1 to P5 on a line L2 indicate open circuit voltages (OCV) of the battery 41 after the charging of the battery 41 is stopped for one minute. When the SoC is 60%, the open circuit voltage of the battery 41 is at the point P1. When the SoC is 65%, the open circuit voltage of the battery 41 is at the point P2. When the SoC is 70%, the open circuit voltage of the battery 41 is at the point P3. When the SoC is 75%, the open circuit voltage of the battery 41 is at the point P4. When the SoC is 80%, the open circuit voltage of the battery 41 is at the point P5.

FIG. 5 illustrates the voltage of the battery 41 at the periphery of the point P1 in FIG. 4. A point P0 on the line L1 illustrated in FIG. 5 indicates the voltage of the battery 41 in step S100. The state acquisition unit 440 acquires the voltage value V1 and the current value I1 at the point P0. The point P1 on the line L2 illustrated in FIG. 5 indicates the voltage of the battery 41 in step S103. The state acquisition unit 440 acquires the voltage value V2 at the point P1.

The impedance value calculation unit 441 calculates the impedance value of the battery 41 by dividing a difference (V1 - V2) between the voltage value V1 and the voltage value V2 by the current value I1. In addition, the impedance value calculation unit 441 calculates the corrected impedance value by multiplying the impedance value by the correction coefficient according to the temperature T.

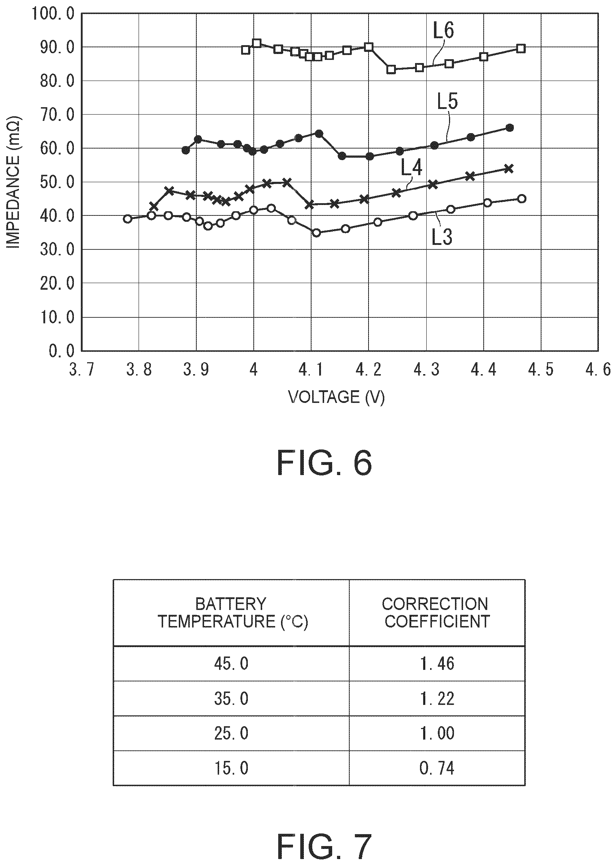

FIG. 6 illustrates an example of an impedance of a battery configured in the same manner as the battery 41. In FIG. 6, a horizontal axis of a graph indicates a voltage of the battery when the SoC is 60%, and a vertical axis of the graph indicates an impedance of the battery. A line L3 in FIG. 6 indicates the impedance at the temperature of 45°C. A line L4 in FIG. 6 indicates the impedance at the temperature of 35°C. Line L5 in FIG. 6 indicates the impedance at the temperature of 25°C. A line L6 in FIG. 6 indicates the impedance at the temperature of 15°C.

For example, by using the battery configured in the same manner as the battery 40, the same processing as the processing of steps S101 to S103 is executed, and the impedance value is calculated. The impedance values at various temperatures are calculated, and data of the graph illustrated in FIG. 6 is obtained. The correction coefficient according to the temperature is calculated by using the data.

FIG. 7 illustrates an example of the correction coefficient. In this example, a reference temperature is 25°C, and the correction coefficient at the reference temperature is set to 1.00. The correction coefficient at each temperature other than the reference temperature is a ratio of the impedance value at each temperature to the impedance value at the reference temperature. The correction coefficient illustrated in FIG. 7 is recorded in the memory 45 in advance.

The correction coefficient increases as the temperature is increased. For example, when the temperature is the reference temperature (25°C), the impedance value calculation unit 441 multiplies the impedance value by a predetermined correction coefficient (1.00). When the temperature is lower than the reference temperature, the impedance value calculation unit 441 multiplies the correction coefficient, which is smaller than the predetermined correction coefficient, by the impedance value. When the temperature is higher than the reference temperature, the impedance value calculation unit 441 multiplies the correction coefficient, which is larger than the predetermined correction coefficient, by the impedance value.

(Step S105)

After step S104 is executed, the memory control unit 443 records the corrected impedance value in the memory 45. The memory control unit 443 may update the corrected impedance value recorded in the memory 45 last time, with the newly calculated corrected impedance value. The memory control unit 443 may record the newly calculated corrected impedance value in the memory 45 in a state of being identifiable from the corrected impedance value calculated in the past. After that, the controller 44 executes step S100 again.

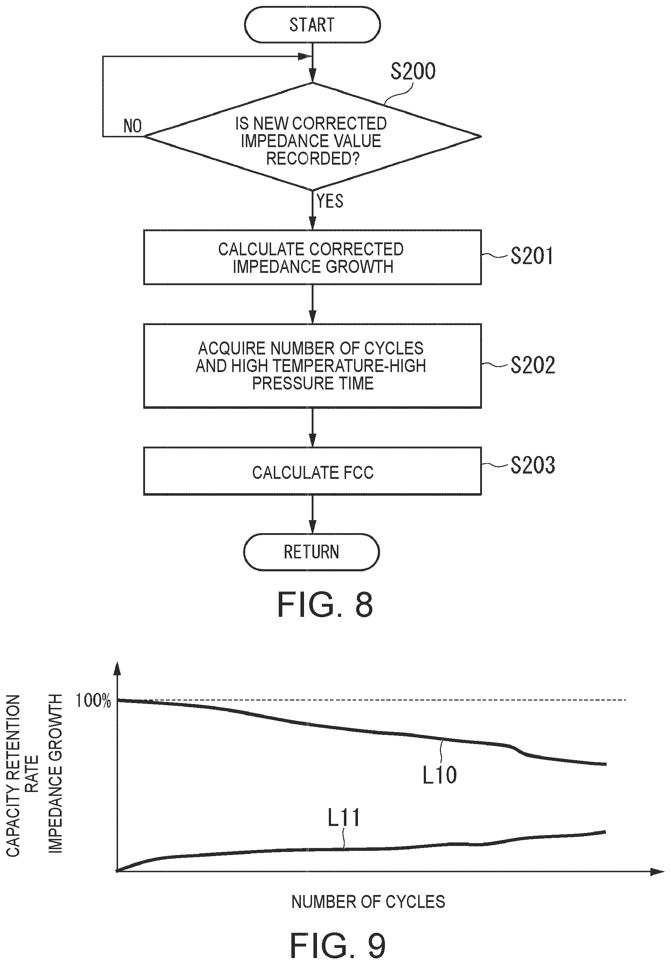

A description of the capacity calculation process executed by the controller 44 will be made with reference to FIG. 8. FIG. 8 illustrates an example of the capacity calculation process according to the present embodiment. The controller 44 executes the capacity calculation process illustrated in FIG. 8 at any time. The controller 44 may execute the capacity calculation process while the battery 41 is in charge or may execute the capacity calculation process when the battery 41 is not being charged.

(Step S200)

The memory control unit 443 determines whether or not the new corrected impedance value is recorded in the memory 45 each time the predetermined time elapses. When the new corrected impedance value is not recorded in the memory 45, the controller 44 executes step S200 again. When the new corrected impedance value is recorded in the memory 45, the controller 44 executes the following step S201.

(Step S201)

The battery capacity calculation unit 442 calculates a corrected impedance growth. The corrected impedance growth is a ratio of the corrected impedance value, which is recorded in the memory 45, to an initial impedance value. The initial impedance value is an impedance value of the battery 41 before the use of the battery 41 is started (before the first charging of the battery 41 is started). The impedance value of the battery 41 is gradually increased from the initial impedance value as time elapses. The initial impedance value is recorded in the memory 45 in advance.

(Step S202)

The state acquisition unit 440 acquires information related to the number of cycles and high temperature-high pressure time from the BMU 42.

One cycle corresponds to a period during when the state of the battery 41 changes from a completely discharged state to a fully charged state and then returns to the completely discharged state. The battery 41 stores the number of cycles, which is from a time point when the use of the battery 41 is started, inside the battery 41.

The high temperature-high pressure time is time (hour) until the temperature of the battery 41 falls within a predetermined temperature range and an output voltage value of the battery 41 falls within a predetermined voltage range. For example, the predetermined temperature range is 45°C or higher and 70°C or lower. For example, the predetermined voltage range is 4.4 V or more and 4.5 V or less.

(Step S203)

After step S202 is executed, the battery capacity calculation unit 442 calculates the full charge capacity of the battery 41 by using the number of cycles, the high temperature-high pressure time, and the corrected impedance growth. The memory control unit 443 records the full charge capacity in the memory 45. After that, the controller 44 executes step S200 again.

An example of a method of calculating the full charge capacity of the battery 41 will be described. FIG. 9 illustrates an example of a relationship between the number of cycles and a capacity retention rate and a relationship between the number of cycles and an impedance growth. As described above, the capacity retention rate is obtained by dividing the design capacity by the full charge capacity. The impedance growth is a ratio of the current impedance value to the initial impedance value.

In FIG. 9, a horizontal axis of a graph indicates the number of cycles, and a vertical axis of the graph indicates the capacity retention rate and the impedance growth. A line L10 illustrated in FIG. 9 indicates a relationship between the number of cycles and the capacity retention rate. A line L11 illustrated in FIG. 9 indicates a relationship between the number of cycles and the impedance growth. As illustrated in FIG. 9, as the number of cycles is increased, the capacity retention rate is decreased and the impedance growth is increased. That is, as the impedance is increased, the full charge capacity is decreased. The battery capacity calculation unit 442 calculates the full charge capacity based on a relationship between the full charge capacity and the impedance.

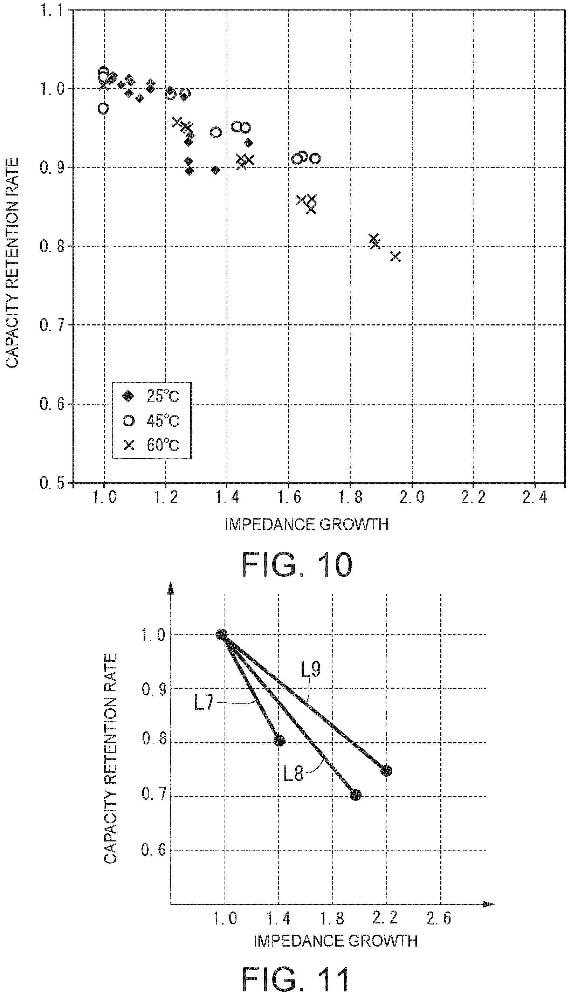

FIG. 10 illustrates an example of a relationship between the impedance growth and the capacity retention rate of the battery configured in the same manner as the battery 41. In FIG. 10, a horizontal axis of a graph indicates the impedance growth, and a vertical axis of the graph indicates the capacity retention rate.

The graph in FIG. 10 is a measurement result of the impedance and the full charge capacity obtained by deteriorating the battery in three different test environments, and respective test environment temperatures are 25°C, 45°C, and 60°C. As illustrated in FIG. 10, it is presumed that the relationship between the impedance and the full charge capacity can be approximated with a straight line.

FIG. 11 illustrates three straight lines that approximate the measurement results illustrated in FIG. 10. The straight line L7 approximates the measurement result in a deterioration mode 1 (test environment temperature of 25°C). The straight line L8 approximates the measurement result in a deterioration mode 2 (test environment temperature of 45°C). The straight line L9 approximates the measurement result in a deterioration mode 3 (test environment temperature of 60°C).

As illustrated in FIG. 11, the relationship between the impedance and the full charge capacity can be approximated with a straight line, and the relationship depends on the temperature. In addition, as illustrated in FIG. 9, the relationship between the number of cycles and the capacity retention rate can be approximated with a straight line. In consideration of these, the full charge capacity FCC of the battery 41 is represented by the following Expression (1) using the number of cycles CYC, the high temperature-high pressure time HTVT, and the corrected impedance growth IMP.

$$FCC = 1.0 + a * CYC + b * HTVT + c * IMP \quad \dots \quad (1)$$

Where, a, b, and c in Expression (1) are predetermined coefficients. By using the battery configured in the same manner as the battery 41, the impedance value and the full charge capacity at various temperatures are measured, and the number of cycles and the high temperature-high pressure time are acquired. As a result, for example, the least squares method is applied, and the coefficient a, the coefficient b, and the coefficient c are calculated. These coefficients are stored in the memory 45 in advance. The controller 44 calculates the full charge capacity by using Expression (1).

As described above, the controller 44 acquires a first voltage value (V1) and a charge current value (I1) of the battery 41 while the battery 41 is in charge. The controller 44 acquires a second voltage value (V2) of the battery 41 while charging of the battery 41 is in pause. The controller 44 calculates the impedance value of the battery 41 by using the first voltage value, the second voltage value, and the charge current value. The controller 44 calculates the impedance growth, which is a ratio of the impedance value to the initial impedance value recorded in the memory 45 in advance. The controller 44 acquires the number of cycles of the battery 41. The controller 44 acquires time (high temperature-high pressure time) until the temperature of the battery 41 falls within the predetermined temperature range and the output voltage value of the battery 41 falls within the predetermined voltage range. The controller 44 calculates the full charge capacity of the battery 41 by using the number of cycles, the impedance growth, and the high temperature-high pressure time.

In the present embodiment, a charging amount and a discharging amount of the battery 41 required for calculating the full charge capacity are small. Therefore, the controller 44 is capable of calculating the full charge capacity at a high frequency.

The controller 44 calculates the full charge capacity according to Expression (1). The controller 44 is capable of calculating the full charge capacity by using a simple expression.

The controller 44 may calculate the full charge capacity without using the high temperature-high pressure time. In this case, the controller 44 does not need to acquire the high temperature-high pressure time from the BMU 42. The controller 44 calculates the full charge capacity by using the following Expression (2) obtained by modifying Expression (1).

$$FCC = 1.0 + a * CYC + c * IMP ... (2)$$

The controller 44 corrects the impedance value according to the temperature while the battery 41 is in charge. The controller 44 calculates the full charge capacity by using the corrected impedance growth according to the temperature. Therefore, the controller 44 is capable of calculating the full charge capacity with high accuracy.

(Second Embodiment)

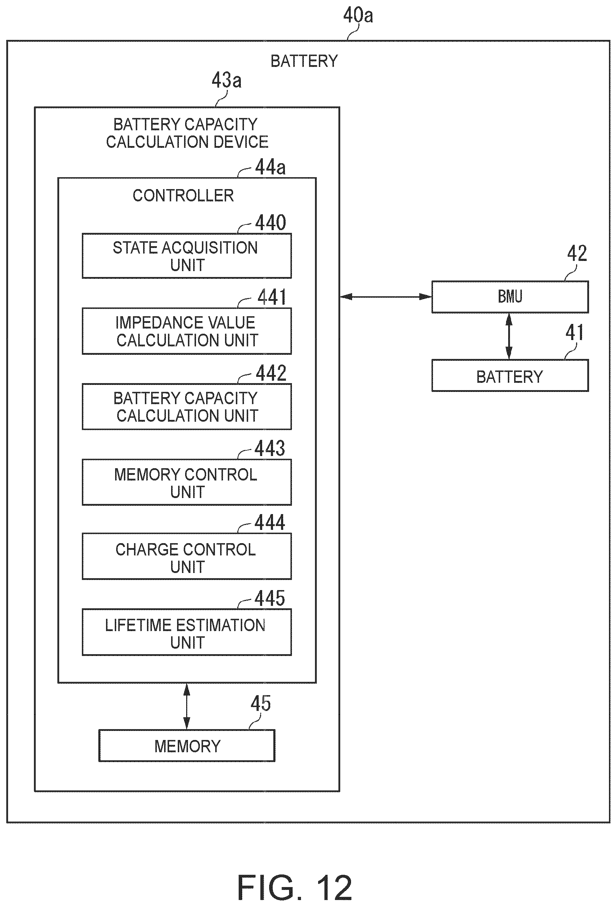

A second embodiment of the present invention will be described. In the second embodiment, a battery 40a illustrated in FIG. 12 is used instead of the battery 40 illustrated in FIG. **2.** FIG. 12 illustrates an example of a configuration of the battery 40a according to the present embodiment. Only a configuration different from the configuration illustrated in FIG. 2 will be described, and the description of the configuration having the same configuration as the configuration illustrated in FIG. 2 will be omitted.

A battery capacity calculation device 43a illustrated in FIG. 12 is used instead of the battery capacity calculation device 43 illustrated in FIG. **2. In** the battery capacity calculation device 43a, a controller 44a is used instead of the controller 44 illustrated in FIG. 2.

The controller 44a includes a lifetime estimation unit 445 in addition to the state acquisition unit 440, the impedance value calculation unit 441, the battery capacity calculation unit 442, the memory control unit 443, and the charge control unit 444 illustrated in FIG. **2.** The lifetime estimation unit 445 calculates time during when the full charge capacity of the battery 41 is equal to or less than a predetermined capacity.

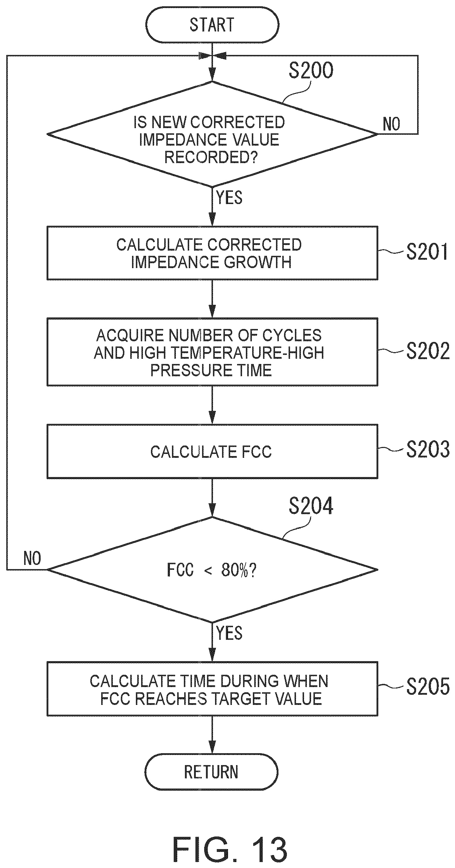

The controller 44a executes a capacity calculation process illustrated in FIG. 13 instead of the capacity calculation process illustrated in FIG. 8. FIG. 13 illustrates an example of the capacity calculation process according to the present embodiment. Only the processing different from the processing illustrated in FIG. 8 will be described, and the description of the processing the same as the processing illustrated in FIG. 8 will be omitted.

Steps S200 to S203 illustrated in FIG. 13 are the same as steps S200 to S203 illustrated in FIG. 8.

(Step S204)

After step S203 is executed, the lifetime estimation unit 445 determines whether or not the full charge capacity (FCC), which is calculated in step S203, is less than 80%. When the full charge capacity is 80% or more, the controller 44a executes step S200. When the full charge capacity is less than 80%, the controller 44a executes step S205.

(Step S205)

The full charge capacity calculated in step S203 and the time information indicating the date on which the full charge capacity is calculated are recorded in the memory 45. The lifetime estimation unit 445 calculates the time during when the full charge capacity reaches a reference capacity, by using the full charge capacity and the time information recorded in the memory 45.

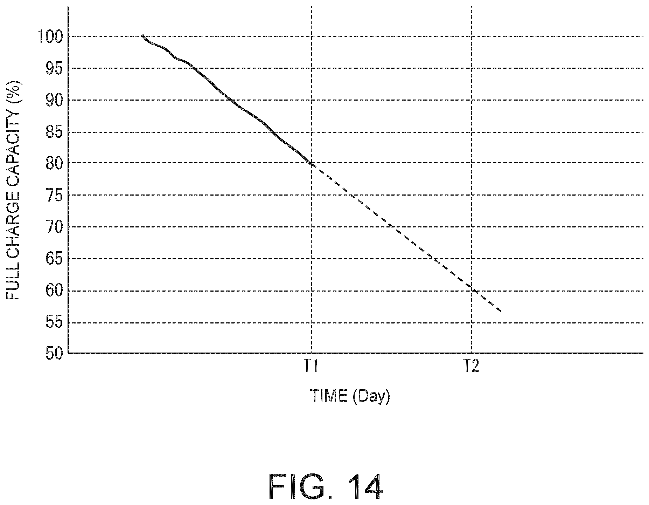

FIG. 14 illustrates an example of a time change in full charge capacity of the battery configured in the same manner as the battery 41. In FIG. 14, a horizontal axis of a graph indicates the time, and a vertical axis indicates the full charge capacity.

The full charge capacity is gradually decreased as time elapses. A relationship between the time and the full charge capacity can be approximated with a straight line. The full charge capacity is 80% on the day indicated by T1.

Thereafter, the full charge capacity is 60% of the reference capacity on the date indicated by T2. The lifetime estimation unit 445 calculates the time between T1 and T2.

Specifically, the lifetime estimation unit 445 calculates an approximate straight line expression indicating the relationship between the time and the full charge capacity by using the past full charge capacity recorded in the memory 45. The lifetime estimation unit 445 calculates the time during when the full charge capacity is changed from 80% to 60% by using the expression. This time serves as a guideline for when the user should replace the battery 41. The lifetime estimation unit 445 may calculate the number of cycles corresponding to the time.

In the above example, although a threshold value in step S204 is 80%, the threshold value may be a value other than 80%. In the above example, although the reference capacity is 60%, the reference capacity may be a value other than 60%.

The time, which is calculated by the lifetime estimation unit 445, may be output to the CPU 11. The CPU 11 may execute a notification process of notifying the user of the time. For example, the CPU 11 may display the information indicating the time on the display unit 14. The CPU 11 may cause a speaker (not illustrated in FIG. 1) to generate an audio corresponding to the information. The CPU 11 may transmit the information to other apparatuses via the WLAN card 25.

As described above, the controller 44 records the calculated full charge capacity and the time information at a time point when the full charge capacity is calculated, in the memory 45. The controller 44 calculates the time during when the full charge capacity of the battery 41 is equal to or less than the predetermined capacity, by using the full charge capacity and the time information recorded in the memory 45. The controller 44 is capable of predicting a lifetime of the battery 41.

Although the embodiment of the present invention has been described in detail with reference to the drawings above, a specific configuration is not limited to the above-described embodiment, and includes design changes within a range not deviating from the scope of the present invention.

Description of Symbols

| 10 | electronic apparatus |
|---|---|
| 11 | CPU |
| 12 | main memory |
| 13 | video subsystem |
| 14 | display unit |
| 21 | chipset |
| 22 | BIOS memory |
| 23 | storage medium |
| 24 | audio system |
| 25 | WLAN card |
| 26 | USB connector |
| 31 | embedded controller |
| 32 | input unit |
| 33 | power supply circuit |
| 40, 40a | battery |
| 41 | battery |
| 42 | BMU |
| 43, 43a | battery capacity calculation device |
| 44, 44a | controller |
| 45 | memory |
| 440 | state acquisition unit |
| 441 | impedance value calculation unit |
| 442 | battery capacity calculation unit |
| 443 | memory control unit |
| 444 | charge control unit |
| 445 | lifetime estimation unit |

**Claims**

1.   A battery capacity calculation device (43, 43a) comprising:

a controller (44, 44a),
wherein the controller is configured to

acquire, while a battery (40, 40a, 41) is in charge, a first voltage value and a charge current value of the battery,
acquire, while charging of the battery is in pause, a second voltage value of the battery,
calculate an impedance value of the battery by using the first voltage value, the second voltage value, and the charge current value,
calculate an impedance growth that is a ratio of the impedance value to an initial impedance value recorded in a memory in advance,
**characterised in that** the controller is configured to
acquire the number of cycles of the battery, and
calculate a full charge capacity of the battery by using the number of cycles and the impedance growth.

2. The battery capacity calculation device according to claim 1, wherein the controller is further configured to

acquire time until a temperature of the battery falls within a predetermined temperature range and an output voltage value of the battery falls within a predetermined voltage range, and
calculate the full charge capacity of the battery by using the number of cycles, the impedance growth, and the time.

3. The battery capacity calculation device according to claim 2,

wherein the controller is configured to calculate the full charge capacity according to an expression: FCC = 1.0 + a * CYC + b * HTVT + c * IMP, and
in the expression, FCC is the full charge capacity, CYC is the number of cycles, HTVT is the time, IMP is the impedance growth, and a, b, and c are predetermined coefficients.

4. The battery capacity calculation device according to claim 2 or 3,
wherein the controller is configured to correct the impedance value according to the temperature of the battery while the battery is in charge.

5. The battery capacity calculation device according to claim 2 or 3,
wherein the controller is configured to

record the calculated full charge capacity and time information at a time point when the full charge capacity is calculated, in a memory (45), and
calculate time during when the full charge capacity of the battery is equal to or less than a predetermined capacity, by using the full charge capacity and the time information recorded in the memory.

6. A battery capacity calculation method comprising:

a step of acquiring, while a battery (40, 40a, 41) is in charge, a first voltage value and a charge current value of the battery;
a step of acquiring, while charging of the battery is in pause, a second voltage value of the battery;
a step of calculating an impedance value of the battery by using the first voltage value, the second voltage value, and the charge current value;
a step of calculating an impedance growth that is a ratio of the impedance value to an initial impedance value recorded in a memory in advance; **characterised by**
a step of acquiring the number of cycles of the battery; and
a step of calculating a full charge capacity of the battery by using the number of cycles and the impedance growth.

7. The battery capacity calculation method of claim 6, further comprising:

a step of acquiring time until a temperature of the battery falls within a predetermined temperature range and an output voltage value of the battery falls within a predetermined voltage range,
wherein the step of calculating the full charge capacity of the battery uses the number of cycles, the impedance growth, and the time.

8. The battery capacity calculation method according to claim 7, further comprising

calculating the full charge capacity according to an expression: FCC = 1.0 + a * CYC + b * HTVT + c * IMP, and in the expression, FCC is the full charge capacity, CYC is the number of cycles, HTVT is the time, IMP is the impedance growth, and a, b, and c are predetermined coefficients.

9. The battery capacity calculation method according to claim 7 or 8, further comprising correcting the impedance value according to the temperature of the battery while the battery is in charge.

10. The battery capacity calculation method according to claim 7 or 8, further comprising

recording the calculated full charge capacity and time information at a time point when the full charge capacity is calculated, in a memory (45), and calculating time during when the full charge capacity of the battery is equal to or less than a predetermined capacity, by using the full charge capacity and the time information recorded in the memory.

**Patentansprüche**

1. Vorrichtung (43, 43a) zur Berechnung der Batteriekapazität, Folgendes umfassend:

eine Steuerung (44, 44a), wobei die Steuerung konfiguriert ist, während des Ladevorgangs einer Batterie (40, 40a, 41) einen ersten Spannungswert und einen Ladestromwert der Batterie zu erfassen, während der Ladevorgang der Batterie unterbrochen ist, einen zweiten Spannungswert der Batterie zu erfassen, einen Impedanzwert der Batterie unter Verwendung des ersten Spannungswerts, des zweiten Spannungswerts und des Ladestromwerts zu berechnen, eine Impedanzzunahme zu berechnen, die ein Verhältnis des Impedanzwerts zu einem zuvor in einem Speicher aufgezeichneten anfänglichen Impedanzwert darstellt, **dadurch gekennzeichnet, dass** die Steuerung konfiguriert ist, die Anzahl der Zyklen der Batterie zu erfassen und die Gesamtladekapazität der Batterie unter Verwendung der Anzahl der Ladezyklen und der Impedanzzunahme zu berechnen.

2. Vorrichtung zur Berechnung der Batteriekapazität nach Anspruch 1, wobei die Steuerung ferner konfiguriert ist,

eine Zeit zu erfassen, bis eine Temperatur der Batterie in einen vorbestimmten Temperaturbereich fällt und ein Ausgangsspannungswert der Batterie in einen vorbestimmten Spannungsbereich fällt, und die Gesamtladekapazität der Batterie unter Verwendung der Anzahl der Zyklen, der Impedanzzunahme und der Zeit zu berechnen.

3. Vorrichtung zur Berechnung der Batteriekapazität nach Anspruch 2,

wobei die Steuerung konfiguriert ist, die Gesamtladekapazität gemäß einem Ausdruck zu berechnen: FCC = 1,0 + a * CYC + b * HTVT + c * IMP und in dem Ausdruck FCC die Gesamtladekapazität ist, CYC die Anzahl der Zyklen ist, HTVT die Zeit ist, IMP die Impedanzzunahme ist und a, b und c vorbestimmte Koeffizienten sind.

4. Vorrichtung zur Berechnung der Batteriekapazität nach Anspruch 2 oder 3, wobei die Steuerung konfiguriert ist, den Impedanzwert während des Ladevorgangs der Batterie gemäß der Temperatur der Batterie zu korrigieren.

5. Vorrichtung zur Berechnung der Batteriekapazität nach Anspruch 2 oder 3,

wobei die Steuerung konfiguriert ist, die berechnete Gesamtladekapazität und Zeitinformationen zu einem Zeitpunkt, zu dem die Gesamtladekapazität berechnet wird, in einem Speicher (45) aufzuzeichnen, und

die Zeit, während der die Gesamtladekapazität der Batterie gleich oder kleiner als eine vorbestimmte Kapazität ist, unter Verwendung der Gesamtladekapazität und der in dem Speicher aufgezeichneten Zeitinformationen zu berechnen.

6. Verfahren zur Berechnung der Batteriekapazität, Folgendes umfassend:

einen Schritt des Erfassens, während des Ladevorgangs einer Batterie (40, 40a, 41), eines ersten Spannungswerts und eines Ladestromwerts der Batterie;
einen Schritt des Erfassens, während der Ladevorgang der Batterie unterbrochen ist, eines zweiten Spannungswerts der Batterie;
einen Schritt des Berechnens eines Impedanzwerts der Batterie unter Verwendung des ersten Spannungswerts, des zweiten Spannungswerts und des Ladestromwerts;
einen Schritt des Berechnens einer Impedanzzunahme, die ein Verhältnis des Impedanzwerts zu einem zuvor in einem Speicher aufgezeichneten anfänglichen Impedanzwert darstellt; **gekennzeichnet durch**
einen Schritt des Erfassens der Anzahl von Zyklen der Batterie; und
einen Schritt des Berechnens einer Gesamtladekapazität der Batterie unter Verwendung der Anzahl der Zyklen und der Impedanzzunahme.

7. Verfahren zur Berechnung der Batteriekapazität nach Anspruch 6, ferner Folgendes umfassend:

einen Schritt des Erfassens der Zeit, bis eine Temperatur der Batterie in einen vorbestimmten Temperaturbereich fällt und ein Ausgangsspannungswert der Batterie in einen vorbestimmten Spannungsbereich fällt,
wobei der Schritt des Berechnens der Gesamtladekapazität der Batterie die Anzahl der Zyklen, die Impedanzzunahme und die Zeit verwendet.

8. Verfahren zur Berechnung der Batteriekapazität nach Anspruch 7, ferner umfassend

Berechnen der Gesamtladekapazität gemäß einem Ausdruck: FCC = 1,0 + a * CYC + b * HTVT + c * IMP, und in dem Ausdruck ist FCC die Gesamtladekapazität, CYC ist die Anzahl der Zyklen, HTVT ist die Zeit, IMP ist die Impedanzzunahme und a, b und c sind vorbestimmte Koeffizienten.

9. Verfahren zur Berechnung der Batteriekapazität nach Anspruch 7 oder 8, ferner umfassend
Korrigieren des Impedanzwerts gemäß der Temperatur der Batterie während des Ladevorgangs der Batterie.

10. Verfahren zur Berechnung der Batteriekapazität nach Anspruch 7 oder 8, ferner umfassend

Aufzeichnen der berechneten Gesamtladekapazität und Zeitinformationen zu einem Zeitpunkt, zu dem die Gesamtladekapazität berechnet wird, in einem Speicher (45) und
Berechnen der Zeit, während der die Gesamtladekapazität der Batterie gleich oder kleiner als eine vorbestimmte Kapazität ist, unter Verwendung der Gesamtladekapazität und der in dem Speicher aufgezeichneten Zeitinformationen.

**Revendications**

1. Dispositif de calcul de capacité de batterie (43, 43a) comprenant :

un dispositif de commande (44, 44a),
dans lequel le dispositif de commande est configuré pour

acquérir, pendant qu'une batterie (40, 40a, 41) est en charge, une première valeur de tension et une valeur de courant de charge de la batterie,
acquérir, pendant que la charge de la batterie est en pause, une seconde valeur de tension de la batterie,
calculer une valeur d'impédance de la batterie à l'aide de la première valeur de tension, de la seconde valeur de tension, et de la valeur de courant de charge,
calculer une croissance d'impédance qui est un rapport de la valeur d'impédance à une valeur d'impédance initiale enregistrée dans une mémoire à l'avance,

**caractérisé en ce que** le dispositif de commande est configuré pour acquérir le nombre de cycles de la batterie, et calculer une capacité de charge totale de la batterie à l'aide du nombre de cycles et de la croissance d'impédance.

2. Dispositif de calcul de capacité de batterie selon la revendication 1, dans lequel le dispositif de commande est en outre configuré pour

    acquérir une durée jusqu'à ce qu'une température de la batterie tombe dans une plage de température prédéterminée et qu'une valeur de tension de sortie de la batterie tombe dans une plage de tension prédéterminée, et
    calculer la capacité de charge totale de la batterie à l'aide du nombre de cycles, de la croissance d'impédance et de la durée.

3. Dispositif de calcul de capacité de batterie selon la revendication 2,
   dans lequel le dispositif de commande est configuré pour calculer la capacité de charge totale selon une expression :
   FCC = 1,0 + a * CYC + b * HTVT + c * IMP, et
   dans l'expression, FCC est la capacité de charge totale, CYC est le nombre de cycles, HTVT est la durée, IMP est la croissance d'impédance, et a, b et c sont des coefficients prédéterminés.

4. Dispositif de calcul de capacité de batterie selon la revendication 2 ou 3,
   dans lequel le dispositif de commande est configuré pour corriger la valeur d'impédance en fonction de la température de la batterie pendant que la batterie est en charge.

5. Dispositif de calcul de capacité de batterie selon la revendication 2 ou 3,
   dans lequel le dispositif de commande est configuré pour

    enregistrer la capacité de charge totale calculée et des informations de durée à un point temporel lorsque la capacité de charge totale est calculée, dans une mémoire (45), et
    calculer la durée pendant laquelle la capacité de charge totale de la batterie est égale ou inférieure à une capacité prédéterminée, à l'aide de la capacité de charge totale et des informations de durée enregistrées dans la mémoire.

6. Procédé de calcul de capacité de batterie comprenant :

    une étape d'acquisition, pendant qu'une batterie (40, 40a, 41) est en charge, d'une première valeur de tension et d'une valeur de courant de charge de la batterie ;
    une étape d'acquisition, pendant que la charge de la batterie est en pause, d'une seconde valeur de tension de la batterie ;
    une étape de calcul d'une valeur d'impédance de la batterie à l'aide de la première valeur de tension, de la seconde valeur de tension, et de la valeur de courant de charge ;
    une étape de calcul d'une croissance d'impédance qui est un rapport de la valeur d'impédance à une valeur d'impédance initiale enregistrée dans une mémoire à l'avance ; **caractérisé par**
    une étape d'acquisition du nombre de cycles de la batterie ; et
    une étape de calcul d'une capacité de charge totale de la batterie à l'aide du nombre de cycles et de la croissance d'impédance.

7. Procédé de calcul de capacité de batterie selon la revendication 6, comprenant en outre :
   une étape d'acquisition de durée jusqu'à ce qu'une température de la batterie tombe dans une plage de température prédéterminée et qu'une valeur de tension de sortie de la batterie tombe dans une plage de tension prédéterminée,
   dans lequel l'étape de calcul de la capacité de charge totale de la batterie utilise le nombre de cycles, la croissance d'impédance et la durée.

8. Procédé de calcul de capacité de batterie selon la revendication 7, comprenant en outre
   le calcul de la capacité de charge totale selon une expression : FCC = 1,0 + a * CYC + b * HTVT + c * IMP, et
   dans l'expression, FCC est la capacité de charge totale, CYC est le nombre de cycles, HTVT est la durée, IMP est la croissance d'impédance, et a, b et c sont des coefficients prédéterminés.

9. Procédé de calcul de capacité de batterie selon la revendication 7 ou 8, comprenant en outre
   la correction de la valeur d'impédance en fonction de la température de la batterie pendant que la batterie est en charge.

10. Procédé de calcul de capacité de batterie selon la revendication 7 ou 8, comprenant en outre

l'enregistrement de la capacité de charge totale calculée et d'informations de durée à un point temporel lorsque la capacité de charge totale est calculée, dans une mémoire (45), et
le calcul de la durée pendant laquelle la capacité de charge totale de la batterie est égale ou inférieure à une capacité prédéterminée, à l'aide de la capacité de charge totale et des informations de durée enregistrées dans la mémoire.

FIG. 1

FIG. 2

START

S100

IS CHARGING
STATE OF BATTERY
PREDETERMINED
STATE?

NO

YES

ACQUIRE VOLTAGE VALUE V1,
CURRENT VALUE I1, AND
TEMPERATURE T
S101

STOP CHARGING FOR ONE
MINUTE
S102

ACQUIRE VOLTAGE VALUE V2
S103

CALCULATE IMPEDANCE VALUE AND
CORRECTED IMPEDANCE VALUE
S104

RECORD CORRECTED
IMPEDANCE VALUE
S105

RETURN

FIG. 3

FIG. 4

$$\text{Impedance} = \frac{V_1 - V_2}{I_1}$$

FIG. 5

FIG. 6

| BATTERY TEMPERATURE (°C) | CORRECTION COEFFICIENT |
|---|---|
| 45. 0 | 1. 46 |
| 35. 0 | 1. 22 |
| 25. 0 | 1. 00 |
| 15. 0 | 0. 74 |

FIG. 7

FIG. 8

FIG. 9

FIG. 10

FIG. 11

FIG. 12

FIG. 13

23

FIG. 14

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2021125320 A

- JP 2019211248 A